# FASCICULE DE BREVET EUROPEEN

(11) **EP 3 474 087 B1**
(45) Date de publication et mention de la délivrance du brevet: **19.02.2020**
(21) Numéro de dépôt: 18201022.3
(22) Date de dépôt: 17.10.2018
(51) Int. Cl.: G04F 5/14

(54) **HORLOGE ATOMIQUE À POMPAGE OPTIQUE ET PROCÉDÉ DE FABRICATION ASSOCIÉ**
ATOMUHR MIT OPTISCHER PUMPFUNKTION, UND HERSTELLUNGSVERFAHREN DAFÜR
OPTICAL PUMPING ATOMIC CLOCK AND ASSOCIATED MANUFACTURING METHOD

(30) Priorité: 23.10.2017 FR 1701098
(43) Date de publication de la demande: 24.04.2019
(73) Titulaire: Thales, 92400 Courbevoie (FR)
(72) Inventeur: DENIS, Philippe, 78141 Vélizy-Villacoublay (FR); FAVARD, Philippe, 78141 Vélizy-Villacoublay (FR); BALDY, Michel, 78141 Vélizy-Villacoublay (FR)
(74) Mandataire: Brunelli, Gérald

(56) Documents cités:
- EP-A1- 1 691 242
- EP-A2- 2 131 500
- EP-A2- 2 154 585
- EP-A2- 2 829 925
- WO-A1-01/15325
- WO-A1-03/078977
- US-A- 4 323 860
- US-A- 5 146 185
- US-B1- 6 172 570
- US-B1- 6 303 928

## Description

La présente invention concerne une horloge atomique à pompage optique et un procédé de fabrication associé.

Le domaine de l'invention est celui des horloges atomiques à pompage optique.

L'idée de base d'une horloge atomique est d'utiliser comme repère de fréquence une transition d'un atome, ion ou molécule qui présente naturellement des qualités métrologiques et qui est accessible. Il faut, pour cela, utiliser une fréquence rigoureusement fixe, possédant un caractère absolu dans le temps et l'espace.

Les transitions atomiques sont considérées comme présentant ce caractère absolu d'invariance dans le temps et dans l'espace. Ce postulat, n'a pas été mis en défaut jusqu'à présent. Le Césium a été choisi pour définir la seconde.

Les horloges atomiques à pompage optique à jet de césium sont bien connues et ont démontré leur fiabilité.

Les horloges atomiques à pompage optique comprennent généralement des tubes césium à pompage optique, ou, en d'autres termes, des résonateur atomique à pompage optique utilisant du césium, qui comprennent un grand nombre d'éléments à l'intérieur d'une enveloppe à vide.

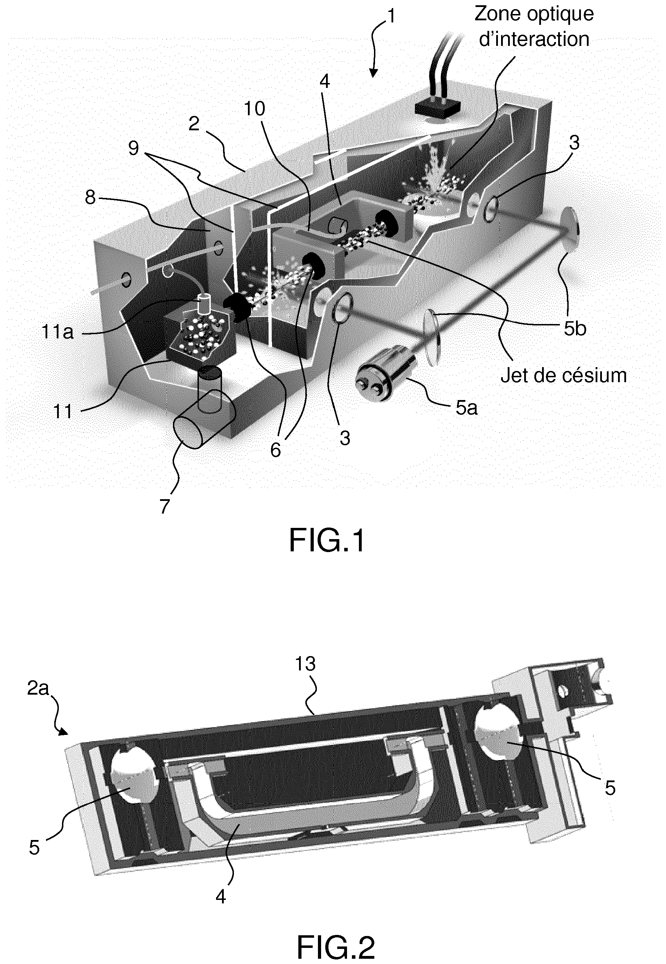

La figure 1 représente schématiquement un résonateur atomique 1 de l'état de l'art, et plus particulièrement sa partie enveloppe à vide 2 équipée d'interfaces optiques 3 comprenant un four à césium 11 et un blindage magnétique 8 traversée par un jet de césium. Le blindage magnétique 8 entoure une cavité résonante 4, des pièges à césium 6 en graphite, une bobine à champ magnétique 9, un câblage RF 10.

Le four à césium 11 de l'enveloppe à vide 2 est disposé à l'extérieur du blindage magnétique 8, ainsi que l'interface 11a de connexion avec le four à césium 11. Une pompe à vide 7 est disposée partiellement à l'extérieur de l'enveloppe à vide 2 et partiellement à l'intérieur, ainsi qu'un banc optique comprenant une source laser 5a et des miroirs optiques 5b disposé à l'extérieur.

De tels résonateurs comprennent environ 250 éléments, qui, pour des contraintes de performance et d'assemblage, sont intégrés à l'intérieur de l'enveloppe ou enceinte à vide. Nombre de ces éléments ont une fonction qui ne nécessite pas de fonctionner sous vide, mais qui sont montés sous vide par contrainte de fabrication, et ces éléments représentent une masse supérieure à 5 kg.

On connaît aussi le document US 6 303 928 B1. Ce document décrit une horloge atomique à pompage optique comprenant un résonateur atomique à pompage optique muni d'une enveloppe à vide équipée d'interfaces optiques. Dans cette horloge atomique, l'enveloppe à vide contient une cavité résonante, avec son blindage magnétique. De plus, certains éléments sont disposés hors de l'enveloppe à vide, et notamment: une bobine à champ magnétique, un câblage RF, une pompe à vide.

Un but de l'invention et de réduire la masse de l'enveloppe à vide en réduisant au maximum son volume.

Un autre but de l'invention est d'éliminer de l'enveloppe à vide des matériaux qui présentent des sensibilités au vide et à la température afin de supprimer des problèmes de dégazage et permettre de réaliser un étuvage à plus haute température.

Un autre but de l'invention est de réduire de manière drastique les coûts de fabrication par la réduction du nombre de pièces et la réduction des étapes de fabrication.

L'invention vise à pallier les problèmes précédemment cités.

Aussi, il est proposé, selon un aspect de l'invention, une horloge atomique à pompage optique comprenant :
- un résonateur atomique à pompage optique muni d'une enveloppe à vide équipée d'interfaces optiques et comprenant, à l'intérieur de l'enveloppe à vide :
   - une cavité résonante,
   - des miroirs optiques, et
   - des pièges à césium en graphite, et
- à l'extérieur de l'enveloppe à vide :
   - une pompe à vide,
   - un blindage magnétique,
   - une bobine à champ magnétique,
   - un câblage RF,
   - un four à césium, et
   - une interface de connexion avec le four à césium.

Ainsi, des éléments habituellement présents dans l'enveloppe à vide sont déportés à l'extérieur de l'enveloppe à vide, ce qui permet de réduire sensiblement son volume et sa masse.

En outre, des matériaux qui présentent des sensibilités au vide et à la température sont éliminés de l'enveloppe à vide, ce qui supprime les problèmes de dégazage et permet de réaliser un étuvage à plus haute température.

Selon un mode de réalisation, l'enveloppe à vide est en titane.

Utiliser une enveloppe à vide en titane, permet de profiter de ses propriétés mécanique et permet d'utiliser l'effet getter de ce type de matériau et permet donc d'améliorer le pompage de l'enceinte sous vide.

Dans un mode de réalisation, l'enveloppe à vide comprend deux parties et une brasure liant les deux parties de l'enveloppe à vide.

Ainsi, toutes les parties internes sous vide sont réalisées dans une même pièce, supprimant les opérations d'alignement.

Par exemple, la brasure peut comprendre du titane.

Utiliser une brasure comprenant du titane, permet de garantir une tenue mécanique optimale.

En variante la brasure peut comprendre de l'or.

Utiliser une brasure comprenant de l'or, permet de garantir un faible dégazage.

En variante la brasure peut comprendre du cuivre.

Utiliser une brasure comprenant du cuivre, permet de garantir un faible dégazage tout en diminuant les coûts de réalisation.

Selon un mode de réalisation, ladite cavité résonante et lesdits composants optiques comprennent un revêtement de cuivre.

Ainsi, il est aisé de faire une reprise mécanique pour assurer des dimensions précises, comme pour la cavité résonante, et on améliore l'état de surface des composants optique pour obtenir un effet miroir.

Il est également proposé, selon un autre aspect de l'invention, un procédé de fabrication d'une horloge atomique tel que défini dans la revendication indépendante 8.

Un tel procédé permet de réduire le nombre de pièces à assembler, et le nombre d'étapes de fabrication, ce qui permet de limiter le coût de fabrication.

Dans un mode de mise en œuvre, le procédé comprend une sous-étape consistant à recouvrir de cuivre la cavité résonante et les composants optiques internes à l'enveloppe à vide.

Selon un mode de mise en œuvre, l'enveloppe à vide est réalisée en titane et la brasure entre les deux parties de l'enveloppe à vide est faite directement.

En variante, l'enveloppe à vide est réalisée en titane et la brasure entre les deux parties de l'enveloppe à vide comprend de l'or.

En variante, l'enveloppe à vide est réalisée en titane et la brasure entre les deux parties de l'enveloppe à vide comprend du cuivre.

L'invention sera mieux comprise à l'étude de quelques modes de réalisation décrits à titre d'exemples nullement limitatifs et illustrés par les dessins annexés sur lesquels :
- la figure 1 illustre schématiquement une enveloppe à vide de résonateur atomique d'une horloge atomique à pompage optique, selon l'état de l'art ;
- les figures 2 et 3 illustrent schématiquement deux parties d'une enveloppe à vide, selon un aspect de l'invention ;
- la figure 4 illustre schématiquement une vue de coupe d'un résonateur atomique d'une horloge atomique à pompage optique, selon un aspect de l'invention ;
- la figure 5 illustre schématiquement une vue d'ensemble d'un résonateur atomique d'une horloge atomique à pompage optique, sans blindage magnétique, selon un aspect de l'invention ; et
- la figure 6 illustre schématiquement une vue d'ensemble d'un résonateur atomique d'une horloge atomique à pompage optique, avec blindage magnétique, selon un aspect de l'invention.

Sur l'ensemble des figures, les éléments ayant des références identiques sont similaires.

Dans la présente description, les modes de réalisation décrits sont nullement limitatifs, et les caractéristiques et fonctions bien connues de l'homme du métier ne sont pas décrites en détails.

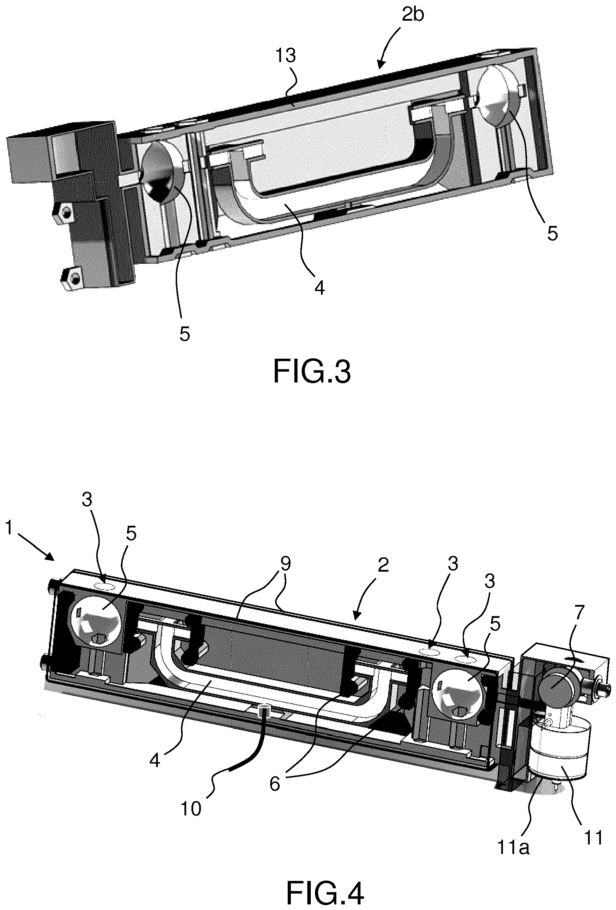

Les figures 2 et 3 représentent deux parties 2a ou 2b de l'enceinte ou enveloppe à vide 2, ou deux demi-enveloppes à vide 2a et 2b, fabriquées par fabrication additive, également appelée impression 3D. Une couche de métal, par exemple du cuivre, est déposée sur des éléments internes, tels les miroirs optiques 5 et la cavité résonante 4, pour assurer les différentes fonctions du résonateur atomique 1.

Ces deux parties 2a, 2b de l'enveloppe à vide 2 sont ensuite assemblées par brasage. La brasure 13 peut être faite directement, i.e. en comprenant du titane, ou peut être effectuée avec une brasure contenant de l'or ou du cuivre.

Ces deux demi-enveloppes 2a, 2b intègrent avant assemblage, en plus de la fonction vide, la cavité résonante 4 (cavité Ramsey), et les zones optiques ou miroirs optiques 5.

Une couche de métal, par exemple du cuivre, est ensuite déposée sur les parties internes de ces deux parties 2a, 2b. Des reprises d'usinages sont ensuite réalisées sur les faces internes de la cavité résonante 4, des miroirs optiques 5 et des interfaces d'assemblage afin d'assurer les fonctions RF, optique et d'assemblage étanche au vide. Sur cet exemple, les interfaces optiques 3 de l'enveloppe à vide 2 sont représentées sur les figures 4, 5 et 6.

Après intégration de pièces additionnelles à l'intérieur du résonateur atomique, tels les pièges à césium (6) en graphite, les deux demi-enveloppes 2a, 2b sont assemblées par brasage sous vide afin d'obtenir une cavité étanche à l'ultra-vide. On entend par ultra-vide un vide poussé à des valeurs inférieures à 1.10⁻⁷ mbar.

La figure 4 représente une vue de coupe d'un résonateur atomique 1 à pompage optique selon un aspect de l'invention. Le résonateur atomique 1 à pompage optique est muni d'une enveloppe à vide 2 équipée d'interfaces optiques 3 et comprend, à l'intérieur de l'enveloppe à vide 2, une cavité résonante 4, des miroirs optiques 5, et des pièges à césium 6 en graphite. En revanche, une pompe à vide 7, un blindage magnétique 8 (non représenté sur cette figure), une bobine à champ magnétique 9, un câblage RF 10, un four à césium 11, et une interface de connexion 11a avec le four à césium 11 sont disposés à l'extérieur de l'enveloppe à vide 2.

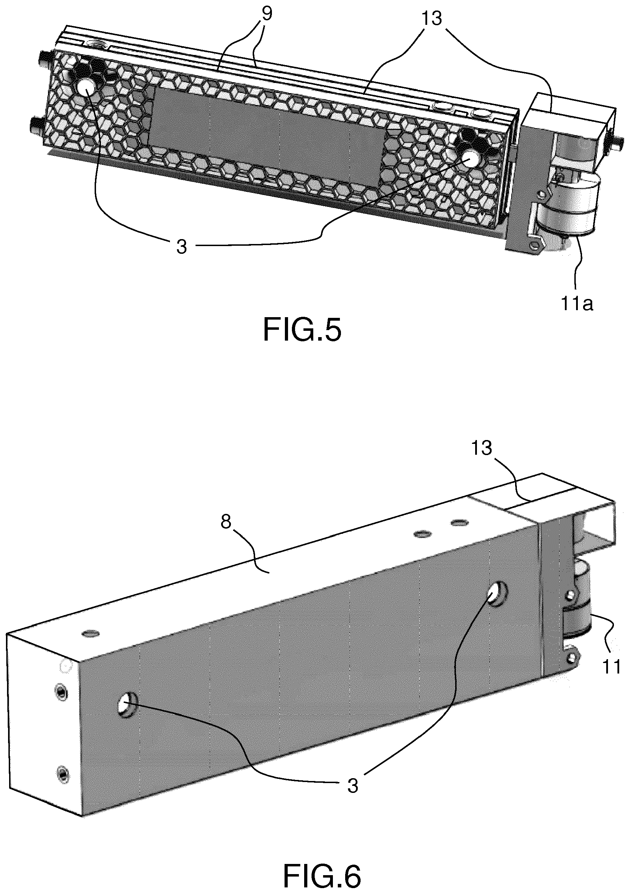

La figure 5 représente une vue d'ensemble d'un résonateur atomique 1 d'une horloge atomique à pompage optique, sans blindage magnétique 8, et la figure 6 représente une vue d'ensemble d'un résonateur atomique 1 de la figure 5, avec un blindage magnétique 8 externe à l'enveloppe à vide 2.

Ainsi, les pièces dont la fonction ne nécessite pas d'être sous vide ou qui présentent une sensibilité au vide peuvent être disposées à l'extérieur de l'enveloppe à vide 2, notamment les aimants de la pompe à vide 7, le blindage magnétique 8, la bobine de champ magnétique 9, le câblage RF 10, le four césium 11 et son interface de connexion 11a.

La présente invention permet la réalisation de deux demi-enveloppes 2a, 2b, de l'enveloppe à vide 2, fabriquées par la technique de fabrication additive ou "additive Manufacturing" en langue anglaise, communément appelée impression 3D, en titane. Dans cette réalisation, une couche de métal, par exemple du cuivre, est déposée sur les parties qui nécessitent soit une reprise mécanique pour assurer des dimensions précises soit des états de surface particuliers comme des miroirs ou des interfaces de brasage.

L'assemblage est réalisé par brasage des différents éléments qui composent le résonateur atomique 1 à césium en une ou plusieurs étapes en fonction de la complexité des pièces à assembler. L'ensemble ainsi formé est débarrassé de tous les matériaux impropres à une utilisation sous ultra-vide, comme les câbles électriques et composants électroniques, les matériaux à bas points de vaporisation tel le Kapton. En outre, la présente invention permet de réaliser en quasiment une seule étape l'assemblage du résonateur complet sans montage mécanique et sans contrainte de réglage des alignements des différents éléments qui sont réalisés directement au niveau de la pièce détachée et qui le composent tels que la cavité résonante 4 (ou cavité Ramsey), les miroirs d'interaction laser 5 et le passage du jet césium.

Enfin, cela permet de simplifier le montage des parties nécessaires au fonctionnement du résonateur 1, en particulier le câblage RF 10 et le montage du blindage magnétique 8, par un accès direct sans contrainte de vide et donc un démontage aisé en cas de dysfonctionnement.

## Revendications

1. Horloge atomique à pompage optique comprenant :
- un résonateur atomique (1) à pompage optique muni d'une enveloppe à vide (2) équipée d'interfaces optiques (3) et comprenant, à l'intérieur de l'enveloppe à vide (2) :
- une cavité résonante (4),
- des miroirs optiques (5), et
- des pièges à césium (6) en graphite, et
- à l'extérieur de l'enveloppe à vide (2) :
- une pompe à vide (7),
- un blindage magnétique (8),
- une bobine à champ magnétique (9),
- un câblage RF (10),
- un four à césium (11), et
- une interface de connexion (11a) avec le four à césium (11).

2. Horloge atomique à pompage optique selon la revendication 1, dans lequel l'enveloppe à vide (2) est en titane.

3. Horloge atomique à pompage optique selon la revendication 1 ou 2, dans lequel l'enveloppe à vide (2) comprend deux parties (2a, 2b) et une brasure (13) liant les deux parties (2a, 2b) de l'enveloppe à vide (2).

4. Horloge atomique à pompage optique selon la revendication 3, dans laquelle la brasure (13) comprend du titane.

5. Horloge atomique à pompage optique selon la revendication 3, dans laquelle la brasure (13) comprend de l'or.

6. Horloge atomique à pompage optique selon la revendication 3, dans laquelle la brasure (13) comprend du cuivre.

7. Horloge atomique à pompage optique selon l'une des revendications précédentes, dans lequel ladite cavité résonante et lesdits composants optiques comprennent un revêtement de cuivre.

8. Procédé de fabrication d'une horloge atomique à pompage optique, comprenant :
- une étape de fabrication d'un résonateur atomique à pompage optique muni d'une enveloppe à vide comprenant les sous-étapes consistant à :
- réaliser deux parties de l'enveloppe à vide par impression 3D ; et
- braser les deux parties de l'enveloppe à vide; et
- une étape de fabrication de l'horloge atomique selon l'une des revendications 1 à 7 en utilisant le résonateur atomique selon l'étape précédente.

9. Procédé selon la revendication 8, comprenant une sous-étape consistant à recouvrir de cuivre la cavité résonante (6) et les composants optiques (5) internes à l'enveloppe à vide (2).

10. Procédé selon la revendication 8 ou 9, dans lequel l'enveloppe à vide (2) est réalisée en titane et la brasure (13) entre les deux parties (2a, 2b) de l'enveloppe à vide (2) est faite directement.

11. Procédé selon la revendication 8 ou 9, dans lequel l'enveloppe à vide (2) est réalisée en titane et la brasure (13) entre les deux parties (2a, 2b) de l'enveloppe à vide (2) comprend de l'or.

12. Procédé selon la revendication 8 ou 9, dans lequel l'enveloppe à vide (2) est réalisée en titane et la brasure (13) entre les deux parties (2a, 2b) de l'enveloppe à vide (2) comprend du cuivre.

## Patentansprüche

1. Atomuhr mit optischer Pumpfunktion, Folgendes beinhaltend:
- einen Atomresonator (1) mit optischer Pumpfunktion, versehen mit einer Vakuumhülle (2), welche mit optischen Schnittstellen (3) ausgerüstet ist, und innerhalb der Vakuumhülle (2) Folgendes beinhaltend:
- einen Resonanzhohlraum (4),
- optische Spiegel (5), und
- Cäsiumfallen (6) aus Graphit, und
- außerhalb der Vakuumhülle (2) :
- eine Vakuumpumpe (7),
- eine magnetische Schirmung (8),
- eine Spule mit Magnetfeld (9),
- eine HF-Verdrahtung (10),
- einen Cäsiumofen (11), und
- eine Anschlussschnittstelle (11a) mit dem Cäsiumofen (11).

2. Atomuhr mit optischer Pumpfunktion nach Anspruch 1, bei welcher die Vakuumhülle (2) aus Titan besteht.

3. Atomuhr mit optischer Pumpfunktion nach Anspruch 1 oder 2, bei welcher die Vakuumhülle (2) zwei Abschnitte (2a, 2b) und eine die beiden Abschnitte (2a, 2b) der Vakuumhülle (2) verbindende Lötverbindung (13) beinhaltet.

4. Atomuhr mit optischer Pumpfunktion nach Anspruch 3, bei welcher die Lötverbindung (13) Titan beinhaltet.

5. Atomuhr mit optischer Pumpfunktion nach Anspruch 3, bei welcher die Lötverbindung (13) Gold beinhaltet.

6. Atomuhr mit optischer Pumpfunktion nach Anspruch 3, bei welcher die Lötverbindung (13) Kupfer beinhaltet.

7. Atomuhr mit optischer Pumpfunktion nach einem der vorhergehenden Ansprüche, bei welchem der Resonanz Hohlraum und die optischen Komponenten eine Kupferbeschichtung beinhalten.

8. Verfahren zur Herstellung einer Atomuhr mit optischer Pumpfunktion, Folgendes beinhaltend:
- einen Schritt des Herstellens eines Atomresonators mit optischer Pumpfunktion, versehen mit einer Vakuumhülle, folgende Unterschritte beinhaltend:
- Herstellen zweier Abschnitte der Vakuumhülle anhand von 3D-Druck; und
- Löten der beiden Abschnitte der Vakuumhülle; und
- einen Schritt des Herstellens der Atomuhr nach einem der Ansprüche 1 bis 7 unter Verwendung des Atomresonators nach dem vorhergehenden Anspruch.

9. Verfahren nach Anspruch 8, beinhaltend einen Unterschritt des Bedeckens des Resonanzhohlraums (6) und der optischen Komponenten (5) im Innern der Vakuumhülle (2) mit Kupfer.

10. Verfahren nach Anspruch 8 oder 9, bei welchem die Vakuumhülle (2) aus Titan besteht und die Lötverbindung (13) zwischen den beiden Abschnitten (2a, 2b) der Vakuumhülle (2) direkt erstellt wird.

11. Verfahren nach Anspruch 8 oder 9, bei welchem die Vakuumhülle (2) aus Titan besteht und die Lötverbindung (13) zwischen den beiden Abschnitten (2a, 2b) der Vakuumhülle (2) Gold beinhaltet.

12. Verfahren nach Anspruch 8 oder 9, bei welchem die Vakuumhülle (2) aus Titan besteht und die Lötverbindung (13) zwischen den beiden Abschnitten (2a, 2b) der Vakuumhülle (2) Kupfer beinhaltet.

## Claims

1. Optically pumped atomic clock comprising:
- an optically pumped atomic resonator (1) provided with a vacuum-tight envelope (2) equipped with optical interfaces (3) and comprising, inside the vacuum-tight envelope (2):
- a resonant cavity (4),
- optical mirrors (5), and
- caesium traps (6) made of graphite, and
- outside the vacuum-tight envelope (2):
- a vacuum pump (7),
- a magnetic shield (8),
- a magnetic field coil (9),
- an RF cable (10),
- a caesium oven (11), and
- an interface (11a) for connection with the caesium oven (11).

2. Optically pumped atomic clock according to Claim 1, wherein the vacuum-tight envelope (2) is made of titanium.

3. Optically pumped atomic clock according to Claim 1 or 2, wherein the vacuum-tight envelope (2) comprises two portions (2a, 2b) and a brazing alloy (13) joining the two portions (2a, 2b) of the vacuum-tight envelope (2).

4. Optically pumped atomic clock according to Claim 3, wherein the brazing alloy (13) comprises titanium.

5. Optically pumped atomic clock according to Claim 3, wherein the brazing alloy (13) comprises gold.

6. Optically pumped atomic clock according to Claim 3, wherein the brazing alloy (13) comprises copper.

7. Optically pumped atomic clock according to one of the preceding claims, wherein said resonant cavity and said optical components comprise a copper coating.

8. Process for manufacturing an optically pumped atomic clock comprising the following steps:
- a step of manufacturing an optically pumped atomic resonator provided with a vacuum-tight envelope comprising sub-steps consisting in:
- producing two portions of the vacuum-tight envelope by 3-D printing; and
- brazing alloying the two portions of the vacuum-tight envelope; and
- a step of manufacturing the atomic clock according to one of claims 1 to 7 using the atomic resonator according to the preceding step.

9. Process according to Claim 8, comprising a sub-step consisting in covering the resonant cavity (6) and the optical components (5) inside the vacuum-tight envelope (2) with copper.

10. Process according to Claim 8 or 9, wherein the vacuum-tight envelope (2) is made of titanium and the brazing alloy (13) between the two portions (2a, 2b) of the vacuum-tight envelope (2) is made directly.

11. Process according to Claim 8 or 9, wherein the vacuum-tight envelope (2) is made of titanium and the brazing alloy (13) between the two portions (2a, 2b) of the vacuum-tight envelope (2) comprises gold.

12. Process according to Claim 8 or 9, wherein the vacuum-tight envelope (2) is made of titanium and the brazing alloy (13) between the two portions (2a, 2b) of the vacuum-tight envelope (2) comprises copper.
